# EUROPEAN PATENT SPECIFICATION

(11) **EP 0 822 268 B1**
(45) Date of publication and mention of the grant of the patent: **26.04.2000**
(21) Application number: 96112277.7
(22) Date of filing: 30.07.1996
(51) Int. Cl.: C23C 16/26, C23C 16/44

(54) **Process for depositing adherent diamond thin films**
Verfahren zur Erzeugung einer haftenden Diamantbeschichtung
Procédé de production d'un revêtement de diamant adhérent

(43) Date of publication of application: 04.02.1998
(73) Proprietor: MICHIGAN STATE UNIVERSITY, East Lansing, Michigan 48824 (US)
(72) Inventor: Ulczynski, Michael J., Okemos, Michigan 48864 (US); Asmussen, Jes, Okemos, Michigan 48864 (US); Reinhard, Donnie K., East Lansing, Michigan 48823 (US)
(74) Representative: Grünecker, Kinkeldey, Stockmair & Schwanhäusser Anwaltssozietät

(56) References cited:
- EP-A- 0 457 076
- THIN SOLID FILMS, vol. 256, no. 1/02, 1 February 1995, pages 13-22, XP000495251 GONON P ET AL: "RAMAN STUDY OF DIAMOND FILMS DEPOSITED BY MPCVD: EFFECT OF THE SUBSTRATE POSITION"
- REVIEW OF SCIENTIFIC INSTRUMENTS, JUNE 1996, AIP, USA, vol. 67, no. 6, ISSN 0034-6748, pages 2360-2365, XP000615708 HIRAMATSU M ET AL: "Hydrogen-radical-assisted radio-frequency plasma-enhanced chemical vapor deposition system for diamond formation"
- 41ST NATIONAL SYMPOSIUM OF THE AMERICAN VACUUM SOCIETY, DENVER, CO, USA, 24-29 OCT. 1994, vol. 13, no. 3, pt.2, ISSN 0734-2101, JOURNAL OF VACUUM SCIENCE & TECHNOLOGY A (VACUUM, SURFACES, AND FILMS), MAY-JUNE 1995, USA, pages 1619-1623, XP000615711 KIM H ET AL: "Effect of the substrate state on the formation of diamond film in a low temperature microwave-plasma-enhanced chemical vapor deposition system"
- JOURNAL OF THE ELECTROCHEMICAL SOCIETY, NOV. 1991, USA, vol. 138, no. 11, ISSN 0013-4651, pages L67-L68, XP000615408 MASOOD A ET AL: "Techniques for patterning of CVD diamond films on non-diamond substrates"
- CHEMISTRY OF MATERIALS, vol. 3, no. 3, 1 May 1991, pages 391-394, XP000321249 NARIMAN K E ET AL: "GROWTH OF FREE-STANDING DIAMOND FILMS ON GLASS"
- DATABASE INSPEC INSTITUTE OF ELECTRICAL ENGINEERS, STEVENAGE, GB Inspec No. 5204928, REIHARD D K ET AL: "Diamond coatings on integrated circuits" XP002021717 & PROCEEDINGS OF THE APPLIED DIAMOND CONFERENCE 1995. APPLICATIONS OF DIAMOND FILMS AND RELATED MATERIALS: THIRD INTERNATIONAL CONFERENCE (NIST SP 885), PROCEEDINGS OF 3RD INTERNATIONAL CONFERENCE ON THE APPLICATIONS OF DIAMOND FILMS AND RELATED MATERI, 1995, GAITHERSBURG, MD, USA, NIST, USA, pages 643-646 vol.1,
- DATABASE INSPEC INSTITUTE OF ELECTRICAL ENGINEERS, STEVENAGE, GB Inspec No. 5204913, ULCZYNSKI M ET AL: "Thin film diamond coatings on glass" XP002021718 & PROCEEDINGS OF THE APPLIED DIAMOND CONFERENCE 1995. APPLICATIONS OF DIAMOND FILMS AND RELATED MATERIALS: THIRD INTERNATIONAL CONFERENCE (NIST SP 885), PROCEEDINGS OF 3RD INTERNATIONAL CONFERENCE ON THE APPLICATIONS OF DIAMOND FILMS AND RELATED MATERI, 1995, GAITHERSBURG, MD, USA, NIST, USA, pages 573-576 vol.1,

## Description

The present invention relates to a plasma assisted chemical vapor deposition (CVD) process for the preparation of an adherent polycrystalline diamond thin film on a substrate, preferably silicon or glass, using relatively low temperatures (less than 600°C). In particular, the process relates to particular conditions for producing the adherent diamond thin film.

Diamond has an exceptionally wide optical transmission window, is resistant to chemical attack at ordinary temperatures, and is expected to be highly resistant to abrasion and erosion (Harris, D. C., Proc. SPIE, **2286**, pp. 218-228 (1994)). Consequently it is of interest as a coating material for other optical materials which are less resistant to hostile environments. The most common optical material is glass; however, diamond film deposition on glass can be problematic. Adhesive diamond films deposited by chemical vapor deposition (CVD) have been reported on quartz, which has a low thermal expansion coefficient (Ong, T. P., et al., Appl. Phys. Lett., **55** 2063-2065 (1989); Pickrell, D. J., et al., J. Mater. Res. **6** 1264-1276 (1991); Muranaka, Y., et al., J. Vac. Sci. Technol. A, **9** 76-84 (1991); and Joseph, A., et al., 2nd International Conference on the Applications of Diamond Films and Related Materials, Eds. M. Yoshikawa, et al., 429-432, MYU, Tokyo (1993)). For glasses with lower softening point temperatures and larger thermal expansion coefficients than pure silica, such as borosilicate glasses, adhesion of CVD diamond films has been reported to be a problem (Nariman, K. E., et al., Chem. Mater. 3 391-394 (1991)).

Diamond is of interest for electronic packaging because of its combination of thermal, electrical and mechanical properties. Diamond is already being used as a substrate material onto which heat producing electronic components are attached (Harris, D. C., Proc. SPIE **2286** 218-228 (1994); and Ong, T. P., et al., Appl. Phys. Lett. **55** 2063-2065 (1989)). In such cases, the high thermal conductivity of diamond combines with its high electrical resistivity and low dielectric constant to provide high-performance heat sinks for microwave integrated circuits, power device modules, and multichip modules (Pickrell, D. J., et al., J. Mater. Res. **6** 1264-1276 (1991); and Muranaka, Y., et al., J. Vac. Sci. Technol. A. **9** 76-84 (1991)). However, diamond is also under consideration as an over-coating layer on microelectronic components. One potential advantage of diamond films on integrated circuits is as a superior passivation layer. In previous work, for example, hot-filament chemical vapor deposition (CVD) was used to deposit a 2 µm thick diamond film on a silicon wafer containing circuitry including linear amplifiers and resistor elements used for thermal transfer printing devices (Joseph A., et al., 2nd International Conference on the Applications of Diamond Films and Related Materials, Eds., M. Yoshikawa, et al., 429-432, MYU, Tokyo (1993)). It was noted that the resulting devices exhibited superior lifetime in that the diamond coated circuits did not exhibit failure due to abrasion of the resistor elements by the paper. However, the diamond deposition temperature of 850°C for this example is too high for conventional microelectronics which use aluminum metallization. Overlay diamond films have also been proposed for improved thermal management of local hot spots in which, for example, diamond would be used as the dielectric material to fill the gap between source-gate and gate-drain regions of high electron mobility transistors (Nariman, K. E., et al., Chem. Mater. **3** 391-394 (1991)). In order to implement such a device, low temperature deposition of diamond is required.

The prior art in chemical vapor deposition of polycrystalline diamond on various substrates is extensive. U.S. Patent No. 4,925,701 to Jansen et al describes a process wherein diamond particles are used for seeding a surface to be coated to produce an adherent film on the surface as tested by the adhesive tape method. The films are particularly useful for protecting electronic circuitry on silicon wafers (IC chips) from heat and mechanical damage. Relatively high temperatures above 650°C were used by Jansen et al which can affect the circuitry on the IC chips. Patents which describe related processes are: U.S. Patent No. 5,311,103 to Asmussen et al; 5,302,231 to Bovenkerk et al; 5,298,286 to Yang et al; 5,286,524 to Slutz et al; 5,270,077 to Knemeyer et al; 5,260,106 to Kawarada et al; 5,243,170 to Maruyama et al; 5,242,711 to DeNatale et al; 5,240,749 to Chow; 5,200,231 to Bachmann et al; 5,230,931 to Yamazaki et al; 5,204,144 to Cann et al; 5,188,862 to Itatani et al; 5,185,179 to Yamazaki et al; 5,183,685 to Yamazaki; 5,180,571 to Hosoya et al; 5,145,711 to Yamazaki et al; and 5,028,451 to Ito et al.

It has been found that the films have relatively poor adhesion to a glass containing substrate either as a result of stresses developed between the film and the substrate in thermal cycling or because the film does not bond well to this substrate. The optical transmission properties of the prior art films are relatively difficult to control. There is a need for improvements in plasma assisted CVD of diamond on silicon containing substrates.

Review of Scientific Instruments, 1996, AIP, USA, Vol. 67, No. 6, pages 2360 to 2365, teaches the deposition of diamond films by plasma enhanced CVD on a mirror polished SI substrate which is pretreated with diamond powder 30 to 40 µm in size. The reaction gas is inter alia CH₄/H₂, the substrate temperature ranges from 400 to 800°C. The partial pressure of CH₄ is 0.6 to 5.3 Pa (5 to 14 m Torr), and 13.3 Pa (100 m Torr) for H₂.

Journal of Vacuum Science and Technology, A, (Vacuum, Surfaces, and Films), May to June 1995, USA, pages 1619 to 1623, reports the low temperature deposition of diamond films by plasma enhanced chemical vapor deposition on SI wafers, quartz and glass substrate, pretreated with diamond powder 30 µm in size. The plasma, wherein the reaction gas is CH₄ premixed with H₂, having a total pressure of 5320 Pa (40 Torr) and wherein the substrate is positioned remote from the plasma.

Therefore, it is the object of the present invention to provide a process which enables to reliably produce an adherent polycrystalline diamond thin film coating have good optical transmission properties on silicon containing substrates, particularly, glass and silicon wafers, which can have integrated micro circuits (i.e., IC chips), said process being economical and easy to perform.

This object is solved by the method of claim 1. Preferred embodiments are disclosed in the dependent claims.

Figure 1 is a photograph showing visibility through a large grain-size, translucent film on the left, which is compared to visibility through a small grain-size, transparent film on the right.

Figure 2 is a graph showing the Raman spectrum for the transparent film shown in Figure 1 which shows a characteristic diamond peak at 1332 cm⁻¹.

Figure 3 is a graph optical transmission through the transparent film shown in Figure 1.

Figure 4 is an optical micrograph of a detail of the diamond film coated IC structure. The lightest colored patterns correspond to aluminum metallization.

Figures 5A and 5B are cross-sectional drawings of a diamond coated bipolar junction transistor with collector (C), emitter (E), and base (B), and a diffused resistor. Solid black is aluminum, dotted gray is oxide and cross-hatched is diamond.

The substrate can be polished with a diamond powder (preferably 0.05 to 1 µm). The substrate can then be subjected to CVD to produce a fine grained film which is more transparent than when the substrate is coated with the diamond particles prior to CVD. Thus the polishing step is preferred. The diamond particles applied to the substrate before CVD have a particle width between about 0.05 and 1 micrometer. This enables the production of the adherent films using the process of the invention. Preferably a photoresist is admixed with the diamond particles such as SHIPLEY 1813, Shipley Marlborough, MA which is a mixture of a resin and a photoactive compound (diazo-oxide). Many such photoresist materials are well known to those skilled in the art. The diamond particles can also be applied to the surface suspended in an organic liquid, such as isopropanol, which is volatilized from the substrate. Spin-coating is preferred as is known in the art.

The gas composition used in the present invention consists essentially of methane and hydrogen and preferably carbon dioxide, as well. This composition forms adherent and clear diamond thin films at low temperatures between 400-600°C and 133 to 2000 Pa (1 to 15 torr). It is believed that the lower thermal stress between the diamond thin film and the substrate which results on cooling contributes to the result.

The mole ratios of the flowing mixed gases are between about 0.90 to 0.99 for hydrogen, 0 to 0.05 for carbon dioxide and 0.01 to 0.05 for methane. The flow rate is preferably 200 SCCM. A flow rate range of 50 SCCM to 500 SCCM can be used. As can be seen, there is always a significant molar excess of hydrogen to maintain reducing conditions in the plasma.

The films produced are generally between about 0.5 and 3.0 micrometers thick. Such films require about 5 to 40 hours to produce on the substrate.

The substrate is preferably a silicon or glassy material, particularly a silicon wafer or borosilicate glass. Glass substrates are difficult to coat.

A positive voltage bias can be applied to the substrate. This enables endless control of film morphology (i.e. crystal size and shape). The bias on the substrate is positive between about 80 and 120 DCV.

The microwaves used to create the plasma are preferably at 2.45 GHz. Other microwave frequencies such as 915 MHz can be used. The power input is preferably 300 to 1500 watts. The preferred apparatus is described in U.S. Patent No. 5,311,103 to Asmussen et al with a graphite support for the substrate. Numerous other configurations for producing a resonant RF or microwave plasma source can be used as is well known to those skilled in the art.

Microwave plasma-assisted chemical vapor deposition can be used to deposit continuous and adhering diamond films on borosilicate glasses that exhibit 70% optical transmission. Such films require low substrate temperatures, between 400°C and 600°C, during deposition.

Diamond over-coatings on substrates which contain microelectronic circuitry provide a means for reduction of thermal hot-spots, or act as a superior passivation layer. This invention includes microwave plasma-assisted chemical vapor deposition of diamond on silicon substrates which contain microelectronic devices. Deposition temperatures are compatible with the aluminum metallization technology commonly used in integrated circuit fabrication. Both passive devices (diffused resistors) and active devices (transistors) are successfully coated.

### EXAMPLE 1

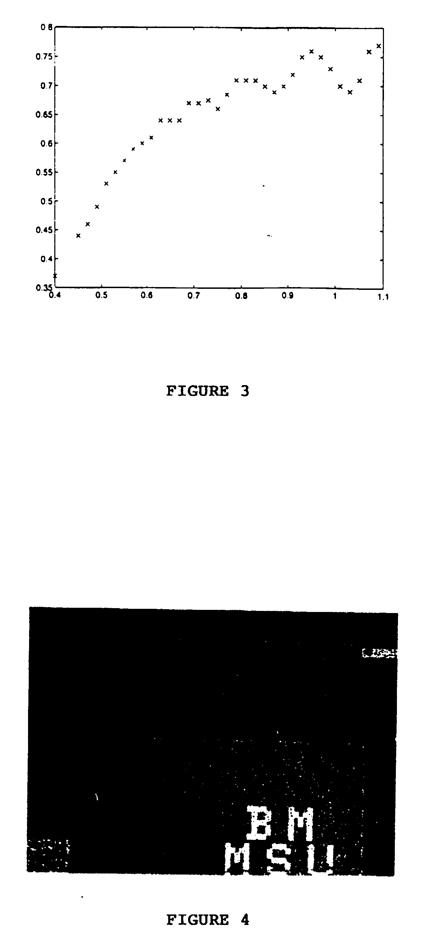

This example illustrates long-term adhesion of diamond films on glass. The apparatus of Figure 4 of U.S. Patent No. 5,311,103 was used.

The substrate was CORNING 7059 glass (Dow Corning, Midland, Michigan) wafer, 5 cm (2 inches) in diameter and 1.1 mm thick. The substrate was seeded by 0.1 micrometer diamond powder suspended in photoresist (SHIPLEY 1813) which was spun onto the wafer. Film deposition was performed in a microwave plasma disk reactor with a 10 cm (4 inch) diameter bell jar at a pressure of 933 Pa (7 torr) and with gas flows of 200 sccm hydrogen, 8 sccm carbon dioxide, and 3 sccm methane. Deposition time was 40 hours, the microwave input power was 350 W, and the substrate temperature as measured with an optical pyrometer was 465°C. The resulting film was continuous as documented by microscopy, and was high-quality polycrystalline diamond as documented by Raman analysis. The average thickness was 1.24 micrometers as determined by weight gain measurements. One year after deposition, the tape-test (performed using 3M Scotch Magic tape, 19 mm wide) still yielded an intact, adhering diamond film on glass.

Using the method of Example 1, diamond was deposited using a low-temperature microwave plasma-assisted CVD method of the present invention. The results are generally described by the inventors in Ulczynski, M. J., et al., Advances in New Diamond Science and Technology, Eds. S. Saito, et al., MYU, Tokyo, (1994). Seeding of the substrates was performed either by a spin-on method as described by Masood et al (Masood, A., et al., J. Electrochem. Soc., **138** L67-L68 (1991)), or by polishing with fine diamond powder. The substrate temperature during deposition was varied between 400°C and 520°C as measured by optical pyrometry. Substrates up to 10 cm in diameter have been coated with deposition rates of 1 mg per hour by this method.

The resulting films are generally in a state of compression since the thermal expansion coefficient of the glass substrates is approximately twice that of diamond. Many films have shown good long-term adhesion with, for example, diamond films on both Corning 7059 and PYREX substrates that pass the tape test for adhesion one year after adhesion, and after repeated thermal cycling to 200°C. Other films, however, have shown spontaneous delamination after times ranging from several minutes to several days after removal from the deposition chamber. The most obvious variables affecting adhesion are deposition temperature and film thickness since film stress increases as both of these parameters increase. Long term adhesion is best achieved when film thicknesses are less than 3 µm and deposition temperatures are less than 480°C.

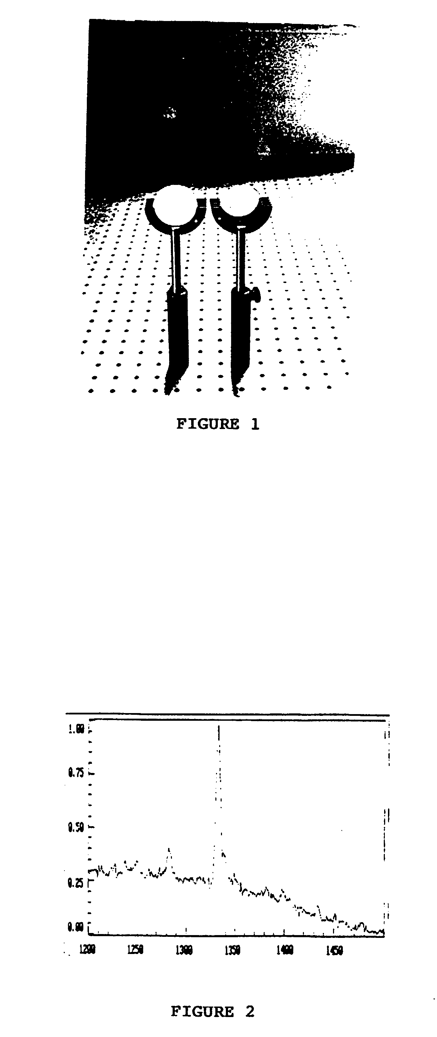

The optical properties of the films are highly dependent on the grain size of the poly-crystalline film. Larger grain films with average grain sizes on the order of a micrometer, are translucent, having the appearance of frosted glass. Objects are clearly visible through such films only if they are directly adjacent to the diamond film. In contrast, smaller grain films, with grain sizes on the order of a quarter-micrometer, are transparent. This difference is illustrated in Figure 1 in which the optical table features are clearly visible through the small grain film, but not the large grain film. Both films however are high quality diamond as indicated by Raman spectroscopy. A Raman spectra, taken with a 30 µm diameter, 488 nm Argon laser, for the transparent film in Figure 1 is shown in Figure 2. The polishing of the glass substrate with the diamond particles resulted in the clear, fine grained films.

The optical transmission of the film/substrate combination was measured from the near ultraviolet to the near infrared. For these measurements, a monochromator beam approximately 0.4 cm in diameter was incident on the back of the glass substrate and 1-cm diameter detector was located 2 cm from the diamond film. Consequently, light reaching the detector is subject to scatter losses in the film. Figure 2 shows the optical transmission as a function of wavelength for the transparent film in Figure 1. The optical interference peak separations indicate a diamond film thickness of approximately 1.18 µm. Transmission values in the red and infrared compare favorably with the ideal value of 75.1% in the absence of interference for a planar, non-absorbing diamond film on the glass substrate, taking the refractive index of diamond as 2.42 and that of the Corning 7059 as 1.53. At smaller wavelengths, the transmission drops, as seen in Figure 2. Previous studies have indicated that the drop in CVD diamond transmission at smaller wavelengths is due to scattering from grain boundaries (Harris, D. C., Proc. SPIE 2286 218-228 (1994)). A plot of the transmission loss deduced from Figure 3 versus the inverse of wavelength shows a fourth-law power dependence, indicative of scattering.

Thus continuous diamond films which show good long term adhesion have been deposited on borosilicate glasses. Optical properties are strongly dependent on grain size, with larger grain size diamond films appearing translucent and smaller grain size diamond films appearing transparent.

### EXAMPLE 2

This example illustrates adhesion of diamond films on glass after temperature-cycling.

The substrate was CORNING 7059 glass wafer, 5 cm (2 inches) in diameter and 1.1 mm thick. The substrate was seeded by 0.1 micrometer diamond powder suspended in photoresist (SHIPLEY 1813) which was spun onto the wafer. Film deposition was performed in a microwave plasma disk reactor with a 12,7 cm (5 inch) diameter bell jar at a pressure of 9 torr and with gas flows of 200 sccm hydrogen, 8 sccm carbon dioxide, and 3 sccm methane. Deposition time was 38 hours, the microwave input power was 1000 W, and the substrate temperature as measured with an optical pyrometer was 450°C. The resulting polycrystalline diamond film was continuous as documented by microscopy, and was high-quality diamond as documented by Raman analysis. The average thickness was 1.0 micrometers as determined by weight gain measurements. The sample was heated to a fixed temperature and then cooled to room temperature in a series of experiments. After each experiment, the tape-test was performed. The temperatures to which the sample was heated were 80°C, 125°C and 210°C. After each experiment, the sample passed the tape-test for adhesion.

### EXAMPLE 3

This example illustrates adhesion of diamond films on glass after temperature-cycling for a different gas composition and a different substrate size.

The substrate was CORNING 7059 glass wafer, 7,6 cm (3 inches) in diameter and 1.1 mm thick. The substrate was seeded by 0.1 micrometer diamond powder suspended in photoresist which was spun onto the wafer. Film deposition was performed in a microwave plasma disk reactor with a 12,7 cm (5 inch) diameter bell jar at a pressure of 1200 Pa (9 torr) and with gas flows of 200 sccm hydrogen and 5 sccm methane. Deposition time was 30 hours, the microwave input power was 1000 W, and the substrate temperature as measured with an optical pyrometer was 470°C. The resulting polycrystalline diamond film was continuous as documented by microscopy, and was high-quality diamond as documented by Raman analysis. The average thickness was 2.0 micrometers as determined by weight gain measurements. The sample was heated to a fixed temperature and then cooled to room temperature in a series of experiments. After each experiment, the tape test was performed. The temperatures to which the sample was heated were 80°C, 125°C, and 210°C. After each experiment, the sample passed the tape-test for adhesion.

### EXAMPLE 4

This example illustrates adhesion of diamond films on glass for a different glass-type.

The substrate was PYREX glass wafer, 5 cm (2 inches) in diameter and 2 mm thick. The substrate was seeded by 0.1 micrometer diamond powder suspended in photoresist SHIPLEY 1813 which was spun onto the wafer. Film deposition was performed in a microwave plasma disk reactor with a 5 inch diameter bell jar at a pressure of 9 torr and with gas flows of 200 sccm hydrogen, 8 sccm carbon dioxide, and 3 sccm methane. Deposition time was 60 hours, the microwave input power was 1000 W, and the substrate temperature as measured with an optical pyrometer was 470°C. The average polycrystalline diamond film thickness was 1.7 micrometers as determined by weight gain measurements. The sample passed the tape-test for adhesion.

### EXAMPLE 5

This example illustrates diamond coating of integrated circuit substrates.

The substrate was a silicon wafer, 5 cm (2 inches) in diameter and 0.3 mm thick. The silicon wafer had been photolithographically processed by conventional oxidation, diffusion, and aluminum metallization to contain a variety of test devices including resistors and transistors. Next, the substrate was seeded by 0.1 micrometer diamond powder suspended in photoresist SHIPLEY 1813 which was spun onto the wafer. Film deposition was performed in a microwave plasma disk reaction with a 10 cm (4 inch) diameter bell jar at a pressure of 933 Pa (7 torr) and with gas flows of 200 sccm hydrogen, 8 sccm carbon dioxide and 3 sccm methane. Deposition time was 40 hours, the microwave input power was 330 W, and the substrate temperature as measured with an optical pyrometer was 435°C. The resulting polycrystalline diamond film was continuous as documented by microscopy. The average thickness was 0.67 micrometers as determined by weight gain measurements. Diamond etching using an oxygen/argon SF6 plasma known in the art was used to expose the device testing pads. The diamond coated resistors and bipolar junction transistors were tested subsequent to this etching procedure and found to be fully functional. The aluminum lines and oxides of various thicknesses and colors which were associated with the underlying electronic devices were clearly visible through the transparent diamond film and were undamaged as assessed by microscopy.

Silicon integrated circuits consist of a variety of materials including silicon, silicon dioxide, and aluminum based metal layer. These represent a wide variety of thermal expansion coefficients and whereas diamond deposition on silicon is well established, deposition on metals and oxides can be problematic. An upper limit on deposition temperature is imposed by the presence of aluminum which has a melting temperature of 660°C. Lower substrate temperatures are advantageous in that differing thermal expansion coefficients can cause considerable intrinsic stress as the substrate and film are cooled from the deposition temperature. Consequently, low-temperature diamond deposition using microwave plasma-assisted chemical vapor deposition was used.

Silicon substrates with (100) orientation were processed to fabricate resistors and bipolar junction transistors. Boron diffusion through oxide windows were used to form diffused resistors and p-type base regions for the transistors. A subsequent phosphorus diffusion was used to form the n-type emitter regions for the transistors, and ohmic contacts to the n-type collectors. Contact cuts were made to the underlying silicon and aluminum was deposited by thermal evaporation. The aluminum layer was patterned and etched by conventional photolithography to form contact pads for device testing purposes. An oxide passivation layer was not used.

Because abrasive seeding techniques can damage the delicate metallization patterns, a spin-on seeding method was used (Masood, A., et al., J. Electrochem. Soc. **138** L67-L68 (1991)). Diamond powder, 0.1 µm, was suspended in photoresist as described in Masood et al and spun onto the wafer. During the first few minutes of exposure to the deposition plasma, the photoresist is etched away, allowing the diamond seed particles to be distributed on the wafer.

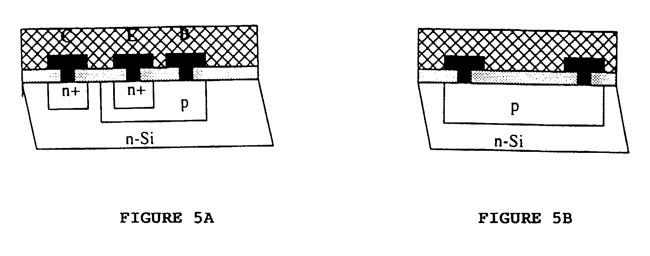

Figure 4 shows a 100X optical micrograph view of details of the IC structure beneath the transparent diamond film. Higher magnification shows the diamond film to be continuous and polycrystalline. The lightest features in Figure 4 correspond to aluminum patterns which are 20 µm wide. The other varying patterns correspond to oxide layers of different thickness. Figures 5A and 5B show cross-sectional drawings through the contact cuts of a resistor and a bipolar transistor. As measured by optical pyrometry, the substrate temperature during deposition was approximately 435°C. Based on before and after weight gain measurements, the diamond film thickness is approximately 0.7 µm.

In order to test the devices after diamond coating, the diamond was selectively removed from the metal contact pads by plasma etching. Previous reports of the selective etching of diamond have included the use of evaporated aluminum (Joseph A., et al., 2nd International Conference on the Applications of Diamond Films and Related Materials, Eds. M. Yoshikawa, et al., 429-432 MYU Tokyo (1993)) and sputtered silicon dioxide (Grot, S. A., et al., "Diamond Thin-Film Recessed Gate Field-Effect Transistors Fabricated by Electron Cyclotron Resonance Plasma Etching (IEEE EDL **13**, 462-464 (1992)) as masking layers. In this investigation, spin-on-glass (SOG) was used as the masking layer. The SOG was patterned by photoresist and wet etching, the photoresist was stripped, and the diamond was etched through to the aluminum test pads. Diamond etching was achieved in an ECR plasma discharge using a mixture of gases including oxygen/argon/SF6. Diamond film coated resistors and transistors were tested subsequent to this etching procedure and found to be fully functional. Alternatively, the photoresist may be patterned prior to deposition. As noted in Masood et al, such seeding is not present where the diamond film is not desired.

Diamond over-coatings are of interest for microelectronics because of potential applications for passivation and reduction of local hot spots. In this Example 5, diamond films have been deposited on silicon integrated circuit structures including transistors and resistors. The deposition temperature is sufficiently low so as to not cause damage to the underlying structures, including the aluminum metallization.

### EXAMPLE 6

This example illustrates achievement of a high degree of optical transparency for diamond film on glass.

The substrate was CORNING 7059 glass wafer, 5 cm (2 inches) in diameter and 1.1 mm thick. The substrate was seeded by polishing with 0.1 micrometer diamond powder and then cleaned. Film deposition was performed in a microwave plasma disk reactor with a 12,7 cm (5 inch) diameter bell jar at a pressure of 1200 Pa (9 torr) and with gas flows of 200 sccm hydrogen, 8 sccm carbon dioxide, and 3 sccm methane. Deposition time was 30 hours, the microwave input power was 1000 W, and the substrate temperature as measured with an optical pyrometer was 470°C. The resulting polycrystalline diamond film was continuous as documented by microscopy, and was high-quality diamond as documented by Raman analysis. The average thickness was 0.6 micrometers as determined by weight gain measurements.

The seeding method produces a high seeding density such that the average grain size as determined by scanning electron microscopy is approximately 0.3 micrometers, resulting in an optically smooth film. Optical transmission was measured with a 0.5 mm diameter HeNe laser beam incident on the back of the glass substrate and a 1 cm diameter detector directly adjacent to the diamond film. The percent transmission was 70%. This is appreciably larger than that measured with larger grain size films (greater than one micrometer grain size) for which the percent transmission is 30%. As a point of reference, calculations based on refractive indices for a perfect planar, non-absorbing diamond film on CORNING 7059 glass, yield a percent transmission of 75% based on reflection at the air/glass; glass/diamond; diamond/air interfaces.

### EXAMPLE 7

This example illustrates the effect of substrate bias on diamond film morphology.

The substrate was a silicon wafer, 5 cm (2 inches) in diameter and 0.3 mm thick. The substrate was seeded by 0.1 micrometer diamond powder suspended in photoresist which was spun onto the wafer. Film deposition was performed in a microwave plasma disk reactor with a 12,7 cm (5 inch) diameter bell jar at a pressure of 2000 Pa (15 torr) and with gas flows of 200 sccm hydrogen, 8 sccm carbon dioxide and 3 sccm methane. Deposition time was 40 hours, the microwave input power was 1000 W, and the substrate temperature as measured with an optical pyrometer was 510°C. The substrate was biased with 100 volts positive dc voltage with a resulting bias current of 8 mA by being placed on a graphite susceptor. The average thickness was 2.2 micrometers as determined by weight gain measurements. The resulting weight gain is comparable to that achieved with no-bias growth conditions, however scanning electron microscopy shows that the film resulting from deposition on a biased substrate exhibits diamond grains which are more clearly faceted than for films produced on non-biased substrates.

As can be seen from Examples 1 to 7, the process of the present invention provides clear and adherent films on silicon containing materials. This result is achieved because of the unique set of processing conditions.

## Claims

1. Method for depositing an adherent diamond thin film on a substrate by chemical-vapor deposition from a plasma, comprising the steps of:
(a) positioning the substrate which has been polished with diamond particles or uniformly coated with diamond particles between about 0.05 and 1 µm in width adjacent to the plasma for deposition of the diamond thin film; and
(b) creating the plasma at a temperature of the substrate of less than 600°C containing a mixture of gases consisting essentially of hydrogen, optionally carbon dioxide, and methane at a pressure of between 133 and 2000 Pa (1 and 15 Torr) to deposit the diamond thin film on the substrate, wherein the diamond thin film is adherent to the substrate.

2. The method of claim 1,
**characterized by**
creating a plasma at a temperature of the substrate of 350-500°C consisting essentially of hydrogen, carbon dioxide and methane.

3. The method of Claim 2 wherein the mole ratios for hydrogen are 0.90 to 0.99, for carbon dioxide are 0.001 to 0.05 and 0.01 to 0.05 for methane.

4. The method of Claim 3 wherein a microwave is selected from the group consisting of 2.45 GHz and 915 MHz is used to produce the plasma.

5. The method of any one of Claims 1 or 2 wherein a positive electrical bias is applied to the substrate.

6. The method of any one of Claims 1 or 2 wherein in the substrate is glass.

7. The method of Claim 6 wherein the glass is a borosilicate glass.

8. The method of Claim 2 wherein the particles of diamond are coated on the substrate in a photoresist composition.

9. The method of Claim 2 wherein the diamond particles are used to polish the substrate.

10. The method of any one of Claims 1 or 2 wherein the substrate is a silicon wafer with electrical circuity which is covered by the diamond thin film.

## Patentansprüche

1. Verfahren zum Abscheiden eines haftenden dünnen Diamantfilms auf einem Substrat durch eine chemische Dampfabscheidung aus einem Plasma, wobei das Verfahren die folgenden Schritte umfaßt:
(a) Das Positionieren des Substrates, welches mit Diamantpartikeln poliert oder einheitlich mit Diamantpartikeln einer Breite von ungefähr 0,05 bis 1 µm beschichtet wurde, neben das Plasma zur Abscheidung des dünnen Diamantfilmes; und
(b) Das Erzeugen des Plasmas bei einer Temperatur des Substrates von weniger als 600°C, wobei das Plasma eine Mischung von Gasen enthält, die im wesentlichen aus Wasserstoff, optional aus Kohlenstoffdioxid, und aus Methan bei einem Druck zwischen 133 und 2000 Pa (1 bis 15 Torr) besteht, um den dünnen Diamantfilm auf dem Substrat abzuscheiden, wobei der dünne Diamantfilm an dem Substrat haftet.

2. Verfahren nach Anspruch 1, **gekennzeichnet durch** das Erzeugen eines Plasmas bei einer Temperatur des Substrates von 350-500°C, wobei das Plasma im wesentlichen aus Wasserstoff, Kohlenstoffdioxid und Methan besteht.

3. Verfahren nach Anspruch 2, **dadurch gekennzeichnet**, daß die Molverhältnisse für Wasserstoff 0,90 bis 0,99, für Kohlendioxid 0,001 bis 0,05 und für Methan 0,01 bis 0,05 sind.

4. Verfahren nach Anspruch 3, **dadurch gekennzeichnet,** daß zur Erzeugung des Plasmas eine Mikrowelle mit einer Frequenz von 2,45 GHz oder 915 MHz ausgewählt wird.

5. Verfahren nach einem der Ansprüche 1 oder 2, **dadurch gekennzeichnet,** daß eine positive elektrische Vorspannung an das Substrat angelegt wird.

6. Verfahren nach einem der Ansprüche 1 oder 2, **dadurch gekennzeichnet,** daß das Substrat aus Glas besteht.

7. Verfahren nach Anspruch 6, **dadurch gekennzeichnet**, daß das Glas ein Glas aus Borsilicat ist.

8. Verfahren nach Anspruch 2, **dadurch gekennzeichnet,** daß die Partikel aus Diamant in einer Zusammensetzung eines Photolacks auf das Substrat beschichtet werden.

9. Verfahren nach Anspruch 2, **dadurch gekennzeichnet**, daß die Partikel aus Diamand zum Polieren des Substrates verwendet werden.

10. Verfahren nach einem der Ansprüche 1 oder 2, **dadurch gekennzeichnet,** daß das Substrat ein Siliciumwafer mit elektrischen Schaltkreisen ist, die durch den dünnen Diamantfilm abgedeckt werden.

## Revendications

1. Procédé pour déposer un film diamanté mince et adhésif sur un substrat par dépôt chimique en phase vapeur à partir d'un plasma, comprenant les étapes consistant :
(a) à positionner le substrat qui a été poli avec des particules de diamant ou recouvert uniformément avec des particules de diamant comprises environ entre 0,05 µm et 1 µm de largeur de façon adjacente au plasma, pour le dépôt du mince film diamanté; et
(b) à créer le plasma à une température du substrat inférieure à 600°C, contenant un mélange de gaz se composant essentiellement d'hydrogène, le cas échéant de dioxyde de carbone, et de méthane, à une pression comprise entre 133 Pa et 2000 Pa (entre 1 torr et 15 torr), pour déposer le mince film diamanté sur le substrat, où le mince film diamanté adhère sur le substrat.

2. Procédé selon la revendication 1, caractérisé par la création d'un plasma à une température du substrat comprise entre 350°C et 500°C, se composant essentiellement d'hydrogène, de dioxyde de carbone et de méthane.

3. Procédé selon la revendication 2, dans lequel les rapports molaires sont compris entre 0,90 et 0,99 pour l'hydrogène, entre 0,001 et 0,05 pour le dioxyde de carbone et entre 0,01 et 0,05 pour le méthane.

4. Procédé selon la revendication 3, dans lequel une micro-onde est sélectionnée parmi le groupe se composant d'une fréquence comprise entre 2,45 GHz et 915 MHz, qui est utilisée pour produire le plasma.

5. Procédé selon la revendication 1 ou 2, dans lequel une polarisation électrique positive est appliquée sur le substrat.

6. Procédé selon la revendication 1 ou 2, dans lequel le substrat est en verre.

7. Procédé selon la revendication 6, dans lequel le verre est un verre de borosilicate.

8. Procédé selon la revendication 2, dans lequel les particules de diamant sont appliquées sur le substrat dans une composition de photorésist.

9. Procédé selon la revendication 2, dans lequel les particules de diamant sont utilisées pour polir le substrat.

10. Procédé selon la revendication 1 ou 2, dans lequel le substrat est une plaquette en silicium comprenant des circuits électriques qui sont recouverts par le mince film diamanté.
